# EUROPEAN PATENT SPECIFICATION

(11) **EP 3 188 424 B1**
(45) Date of publication and mention of the grant of the patent: **06.03.2019**
(21) Application number: 16202395.6
(22) Date of filing: 06.12.2016
(51) Int. Cl.: H04L 25/02

(54) **TRANSMITTER OUTPUT DRIVER CIRCUITS FOR HIGH DATA RATE APPLICATIONS, AND METHODS OF THEIR OPERATION**
SENDERAUSGANGSTREIBERSCHALTUNGEN FÜR ANWENDUNGEN MIT HOHER DATENRATE UND VERFAHREN ZU DEREN BETRIEB
CIRCUITS D'ATTAQUE DE SORTIE D'ÉMETTEUR POUR DES APPLICATIONS À DÉBIT BINAIRE ÉLEVÉ ET LEURS PROCÉDÉS DE FONCTIONNEMENT

(30) Priority: 29.12.2015 US 201514982115
(43) Date of publication of application: 05.07.2017
(73) Proprietor: NXP USA, Inc., Austin TX 78735 (US)
(72) Inventor: HUNTER, Earl K, 5656 AG Eindhoven (NL); PREBLE, Bryan, 5656 AG Eindhoven (NL)
(74) Representative: Pomper, Till

(56) References cited:
- US-A1- 2013 002 311
- US-B1- 7 061 279
- PILLAI E ET AL: "Novel T-Coil Structure and Implementation in a 6.4-Gb/s CMOS Receiver to Meet Return Loss Specifications", ELECTRONIC COMPONENTS AND TECHNOLOGY CONFERENCE, 2007. ECTC '07. PROCEEDINGS. 57TH, IEEE, PI, 1 May 2007 (2007-05-01), pages 147-153, XP031180490, DOI: 10.1109/ECTC.2007.373789 ISBN: 978-1-4244-0984-6

## Description

### TECHNICAL FIELD

Embodiments of the subject matter described herein relate generally to on-chip differential output drivers in point-to-point communication systems, and methods of their operation.

### BACKGROUND

Devices known as serializers/deserializers (or "SerDes") are commonly used in high-speed, point-to-point communications systems to exchange data between transmitters and receivers. In the transmitter, a transmitter-side SerDes receives parallel data signals from a parallel data bus, and converts the signals into a serialized bit stream. The serialized bit stream is fed into a differential line driver (or "differential signal buffer" or "differential output driver"), which drives the serialized bit stream out onto a single-ended or differential channel. In the receiver, and assuming a differential channel, a receiver-side SerDes receives the serialized bit stream from the channel, and feeds it into a differential signal input buffer. The input buffer performs clock recovery, and converts the incoming bits into a serial bit stream. The serial bit stream is then de-serialized (i.e., converted back into parallel data signals).

In the transmitter-side SerDes, a conventional differential line driver may be implemented as a current mode driver or a voltage mode driver. The performance of both of these types of drivers may be quantified by bandwidth, jitter, amplitude, power consumption, common mode noise, and return loss, among other things. When compared with each other, conventional current mode drivers and voltage mode drivers have various performance advantages and disadvantages. As data rates continue to climb, developers of differential line drivers continually strive to design drivers with improved performance.

US7061279 describes an apparatus for increasing output gain of an electronic circuit that includes an output terminal, a complementary data switch pair including first and second transistors, and a load inductor, connected to the first and second transistors.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIG. 1 is a simplified block diagram of a portion of a point-to-point SerDes-type communication system that includes on-chip transmitter and receiver I/O circuits that are communicatively coupled through a differential channel;
FIG. 2 is a simplified circuit diagram of an on-chip differential output driver circuit that may be used in a transmitter I/O circuit, in accordance with an embodiment;
FIG. 3 is a flowchart of a method of operating an embodiment of a differential output driver circuit that may be incorporated into a transmitter of a SerDes system;
FIG. 4 is a chart illustrating differential return loss versus frequency for a conventional on-chip differential output driver circuit, and an on-chip differential output driver circuit with a T-coil implementation, according to an embodiment;
FIG. 5 is a chart illustrating normalized gain versus frequency for a conventional on-chip differential output driver circuit, and an on-chip differential output driver circuit with a T-coil implementation, according to an embodiment;
FIG. 6 illustrates a transient eye diagram for a conventional output driver circuit; and
FIG. 7 illustrates a transient eye diagram for an embodiment of an output driver circuit with a T-coil implementation.

### DETAILED DESCRIPTION

Embodiments of the inventive subject matter include push-pull current mode output driver circuits, which are suitable for use in high data rate transmitters. For example, as will be described in detail below, the output driver circuit embodiments may be used in a serializer/deserializer (SerDes) type of system, in which a serializer within the transmitter provides a serialized bit stream to an embodiment of an on-chip output driver circuit, and the output driver circuit drives signals representing the bit stream onto a differential a channel. In some embodiments, the channel may be an on-chip channel, and in other embodiments, the channel may be an off-chip channel. As used herein, the term "on-chip" means integrated within or directly coupled to an integrated circuit (IC) (e.g., a semiconductor chip), such as a transmitter IC, a receiver IC, or a transceiver IC. Conversely, as used herein, the term "off-chip" means coupled to a substrate other than an IC, such as a printed circuit board (PCB) or some other type of module substrate (e.g., a multi-chip module substrate).

Although implementation of the various embodiments in a SerDes type of system is illustrated in the figures and described in detail below, it should be understood that the below-described output driver circuit embodiments also may be implemented in a variety of other transmitter types. Essentially, the output driver circuit embodiments may be implemented in any type of on-chip transmitter that drives complementary data onto a differential channel (e.g., an on-chip or off-chip channel), and which includes a serial link termination. As will be described in detail later, an on-chip I/O (input/output) circuit in the transmitter includes push-pull output drivers (or push-pull complementary data switch pairs) with positively coupled T-coil circuits that are configured to filter on-die output capacitance and provide bandwidth enhancement. This may result in improved return loss and increased bandwidth, when compared with conventional I/O circuits. As is known, relatively low return loss and wider bandwidth near a center operational frequency of interest are desirable performance goals, which may enable a system to better meet high-speed performance requirements.

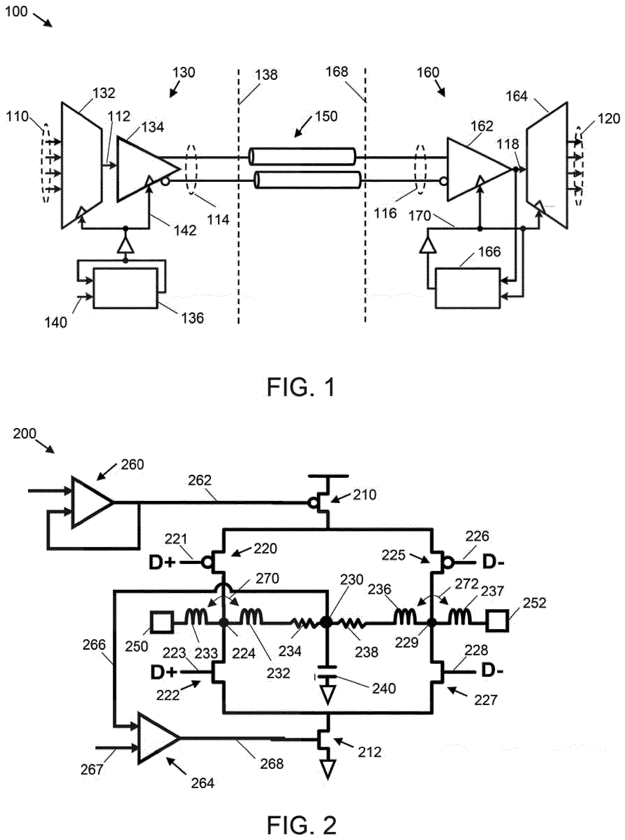

FIG. 1 is a simplified block diagram of a portion of a point-to-point SerDes-type communication system 100 that includes on-chip transmitter and receiver I/O circuits 130, 160 that are communicatively coupled through a differential channel 150 (e.g., an on-chip channel or an off-chip channel). Although not shown, the transmitter I/O circuit 130 forms a portion of a transmitter integrated circuit (IC), where the transmitter IC boundary is indicated with dashed line 138. The non-illustrated portion of the transmitter is configured to produce parallel transmit data signals 110, which are provided to the transmitter I/O circuit 130. Similarly, although not shown, the receiver I/O circuit 160 forms a portion of a receiver IC, where the receiver IC boundary is indicated with dashed line 168. The non-illustrated portion of the receiver is configured to receive and process parallel receive data signals 120 that are produced by the receiver I/O circuit 160.

The transmitter I/O circuit 160 includes a serializer 132, an embodiment of a differential output driver 134, and a phase locked loop (PLL) circuit 136. The serializer 132 is configured to receive parallel transmit data signals 110 from a parallel data bus (not shown) of the transmitter, and to convert the parallel transmit data signals 110 into a serialized bit stream 112. Sampling of the parallel transmit data signals 110 and outputting of the serialized bit stream 112 by the serializer 132 is controlled by a high-speed clock signal 142 provided by the PLL 136.

The PLL 136 is driven by a high-quality reference clock signal 140, which may have a clock frequency substantially equal to the rate at which the serializer 132 clocks in the parallel transmit data signals 110 (referred to herein as the "parallel data clock rate"). Using the reference clock signal 140, the PLL 136 produces the high-speed clock signal 142 at a clock frequency that is substantially equal to the parallel data clock rate multiplied by *N,* where *N* is the number of parallel transmit data signals 110. For example, in a system in which the parallel data bus provides ten parallel transmit data signals 110, and in which the clock frequency of the reference clock signal 140 is 1.4 gigahertz (GHz), the high-speed clock signal 142 may have a clock frequency of 14 GHz. In such an embodiment, the data rate of the serialized bit stream 112 (referred to herein as the "serial data rate") would be twice the clock frequency, or 28 gigabits per second (Gbps).

The serialized bit stream 112 produced by the serializer 132 is provided to the differential output driver 134, which is configured to drive the serialized bit stream 112 out onto the differential channel 150 as a differential transmit data signal 114. As will be described in more detail in conjunction with FIG. 2, an embodiment of the differential output driver 134 includes a push-pull complementary data switch pair with a positively-coupled T-coil configuration, where the T-coil configuration is configured to filter on-die output capacitance that may be associated with the on-chip I/O circuit 130 and/or an on-chip electrostatic discharge (ESD) circuit (not illustrated). This may result in improved return loss and bandwidth extension, when compared with conventional output driver circuits, thus enabling the transmitter I/O circuit 160 to meet performance requirements for relatively high-speed data communications.

The differential channel 150 may include, for example, conductive wires (e.g., a twisted pair) or conductive traces coupled to a printed circuit board. Because the channel 150 may impart distortion, attenuation, and other signal effects to the differential transmit data signal 114, the corresponding data signal received by the receiver I/O circuit 160 is differentiated from the differential transmit data signal 114 by referring to it as a differential receive data signal 116.

The on-chip receiver I/O circuit 160 includes a differential signal input buffer 162, a de-serializer 164, and a timing recovery circuit 166. Using a high-speed clock signal 170 from the timing recovery circuit 166, the differential signal input buffer 162 samples the differential receive data signal 116, and produces a serialized bit stream 118. Essentially, the timing recovery circuit 166 produces the high-speed clock signal 170 at a clock frequency that is substantially the same as the clock frequency of the high-speed clock signal 142 produced by the PLL 136 on the transmitter side. Using the high-speed clock signal 170 from the timing recovery circuit 166, the de-serializer 164 converts the serialized bit stream 118 into parallel receive data signals 120, which are provided to a parallel data bus (not shown) of the receiver.

FIG. 2 is a simplified circuit diagram of an on-chip differential output driver circuit 200 (e.g., output driver circuit 134, FIG. 1) that may be used in a transmitter I/O circuit (e.g., I/O circuit 130, FIG. 1), in accordance with an embodiment. The differential output driver circuit 200 includes two parallel-coupled, push-pull complementary data switch pairs, each with a positively coupled T-coil circuit. Each of the two data switch pairs is configured to produce a different one of the two complementary signals of a differential pair of output signal. As used herein, the term "complementary signals" means signals that are inverses of each other (e.g., 180 degrees out of phase with each other).

The data switch pairs, referred to below as a D+ data switch pair and a D- data switch pair, are coupled in parallel with each other between a high-side current source and a low-side current source. Essentially, the D+ data switch pair transmits a non-inverted version of an input serial bit stream, D+ (e.g., a non-inverted version of serialized bit stream 112, FIG. 1), in order to produce a first output signal at a first differential output terminal 250 (e.g., an I/O pad of the transmitter IC). Similarly, the D- data switch pair transmits an inverted version of an input serial bit stream, D- (e.g., an inverted version of serialized bit stream 112, FIG. 1), in order to produce a second output signal at a second differential output terminal 252 (e.g., another I/O pad of the transmitter IC). The first and second differential output terminals 250, 252, in turn, may be coupled to a differential channel (e.g., channel 150, FIG. 1).

In the illustrated embodiment, the transistors 220, 222, 225, 227 of each data switch pair include complementary (i.e., of opposite conductivity types) metal oxide semiconductor (CMOS) field effect transistors (FETs), where each transistor includes a control terminal (e.g., a gate terminal) and first and second current conducting terminals (e.g., a source terminal and a drain terminal, or vice versa). As is known, a variable signal applied to the control terminal affects the electrical conductivity of a channel between the first and second current carrying terminals, and thus the current flow through the channel.

According to an embodiment, a first pair of CMOS transistors composing the D+ data switch pair includes a P-channel transistor 220 and an N-channel transistor 222. The source of the P-channel transistor 220 is coupled to the high-side current source, and the source of the N-channel transistor 222 is coupled to the low-side current source. The drains of the transistors 220, 222 are coupled together at output node 224, which in turn is coupled to the first differential output terminal 250. The gates 221, 223 of transistors 220, 222 are coupled together to receive the non-inverted version of the input serial bit stream, D+.

A second pair of complementary transistors composing the D- data switch pair also includes a P-channel transistor 225 and an N-channel transistor 227. The source of the P-channel transistor 225 is coupled to the high-side current source (and to the source of P-channel transistor 220), and the source of the N-channel transistor 227 is coupled to the low-side current source (and to the source of N-channel transistor 222). The drains of the transistors 225, 227 are coupled together at output node 229, which in turn is coupled to the second differential output terminal 252. The gates 226, 228 of transistors 225, 227 are coupled together to receive the inverted version of the input serial bit stream, D-.

According to an embodiment, the high-side current source includes a P-channel transistor 210 with its source coupled to a voltage supply (e.g., Vdd), and its drain coupled to the sources of P-channel transistors 220, 225. The gate of transistor 210 is coupled to the output of a bias circuit 260, which provides a relatively constant bias voltage 262 (e.g., Vbp) to transistor 210. During operation, the high-side current source is biased to provide a relatively constant current to the push-pull output driver (e.g., 10 milliamps (mA) or some other current level).

According to an embodiment, the low-side current source includes an N-channel transistor 212 with its source coupled to the sources of N-channel transistors 222, 227, and its drain coupled to a ground reference voltage (e.g., Vss). The gate of transistor 212 is coupled to the output of a bias circuit 264, which provides a bias voltage 268 (e.g., Vocm) that is dependent on the difference between a reference voltage 267 and the voltage at a common mode node 230, as will be discussed in more detail below. During normal operations, the current through the high-side and low-side current sources is substantially equal.

According to an embodiment, the output nodes 224, 229 of the D+ and D- data switch pairs are coupled to a differential termination circuit, which includes termination resistors 234 and 238. More specifically, a first termination resistor 234 is coupled between the first output node 224 and a common mode node 230, and a second termination resistor 238 is coupled between the second output node 229 and the common mode node 230. The termination resistors 234, 238 are configured to match the impedance of the on-chip circuitry with the channel (e.g., channel 150, FIG. 1). For example, the termination resistors 234, 238 each may have values of about 50 ohms for a channel with a 50 ohm impedance. Of course, the impedance of the channel and correspondingly the values of the termination resistors 234, 238 may have smaller or larger values, as well.

According to an embodiment, the common mode node 230 is coupled to a ground reference voltage through a common mode capacitor 240. Desirably, the common mode capacitor 240 has a relatively large value to provide a very low AC impedance to ground. For example, capacitor 240 may have a value of about 10 picofarads, although larger or smaller capacitance values may be used, as well.

According to an embodiment, the center tap of a positively coupled T-coil also is coupled to each output node 224, 229. More specifically, a first T-coil includes a primary inductance 232 (or primary coil) coupled between the first output node 224 and the first termination resistor 234, and a secondary inductance 233 (or secondary coil) coupled between the first output node 224 and the first differential output terminal 250. Similarly, a second T-coil includes a primary inductance 236 (or primary coil) coupled between the second output node 229 and the second termination resistor 238, and a secondary inductance 237 (or secondary coil) coupled between the second output node 229 and the second differential output terminal 252. On the transmitter IC, each T-coil may be implemented as a pair of positively coupled, integrated inductors, such as aligned spiral inductors that are fabricated using different metal layers of the IC. The mutual coupling (e.g., the positive mutual coupling) of the primary and secondary inductances 232, 233, 236, 237 of the first and second T-coils is indicated by arrows 270, 272.

According to an embodiment, the T-coil inductances 232, 233, 236, 237 are configured so that their mutual inductances (e.g., their positive mutual inductances) will substantially filter out (or compensate for) the on-chip output capacitance of each push-pull complementary data switch pair, which tends to be highest at the output nodes 224, 229. This may provide a matching effect for return loss at the desired frequency of interest. Further, the primary coil of each T-coil (e.g., inductances 232, 236) may provide a shunt-peaking effect for bandwidth extension. The T-coil inductances 232, 233, 236, 237 should be designed to have inductance values that are appropriate for the serial data rate and the magnitude of the on-chip output capacitances for which the T-coils are intended to compensate. For example, in a transmitter configured to support a 28 Gbps serial data rate, each inductance 232, 233, 236, 237 may have an inductance value of about 400 picohenries (pH), although larger or smaller inductance values may be used, as well.

Although the various transistors 210, 212, 220, 222, 226, 228 are illustrated to have particular conductivity types (e.g., P-type or N-type), those of skill in the art would understand, based on the description herein, that the conductivity types of the various transistors 210, 212, 220, 222, 226, 228 could be opposite those illustrated in FIG. 2. Further, although the illustrated and described embodiments include MOSFETs 210, 212, 220, 222, 226, 228, alternate embodiments may include bipolar junction transistors (BJTs) instead of MOSFETs. Further still, embodiments of the on-chip differential output driver circuit 200 may be used for transmitter ICs that include ESD circuitry (not shown) that is placed at either the output node (e.g., output node 224, 229) or at the differential output (e.g., differential output terminal 250, 252).

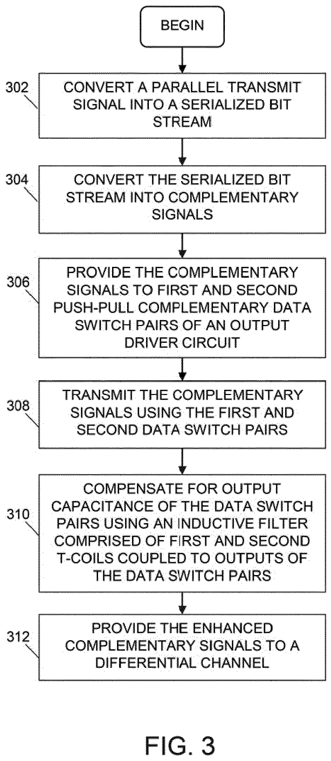

FIG. 3 is a flowchart of a method of operating an embodiment of a differential output driver circuit that may be incorporated into a transmitter IC of a SerDes system, or another system that is configured to modify the serial data in a manner that accounts for and/or mitigates negative effect of high frequency losses (e.g., to enhance the serial data), and to drive the modified serial data onto a differential channel. Those of skill in the art would understand, based on the description herein, how to modify the below-described method for performance on a single-ended output driver.

The method may begin, in block 302, by converting (e.g., by serializer 132, FIG. 1) a parallel transmit signal into a serialized bit stream. In block 304, the serialized bit stream is converted into complementary signals (e.g., D+ and D-). In block 306, the complementary signals are provided to first and second, parallel-coupled, push-pull complementary data switch pairs of an output driver circuit (e.g., output driver circuit 200, FIG. 2). In block 308, the complementary signals are modified (e.g., enhanced) using the first and second complementary data switch pairs. In block 310, output capacitance of the first and second complementary data switch pairs is compensated for using first and second T-coils that are coupled to outputs of the first and second complementary data switch pairs. Finally, in block 312, the modified and compensated complementary signals are provided to a differential channel (e.g., channel 150, FIG. 1).

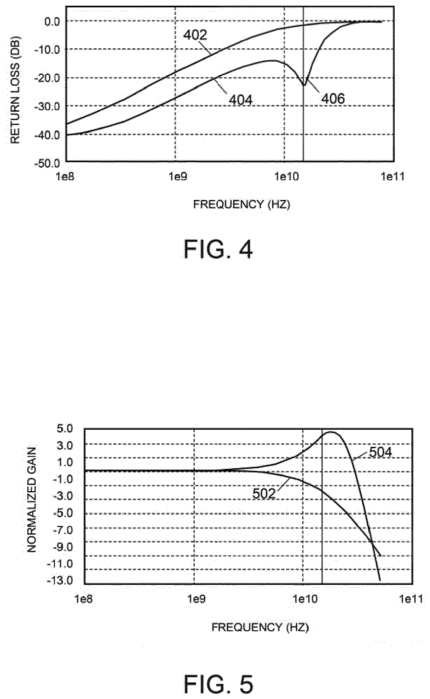

As mentioned above, embodiments of the on-chip differential output driver circuits discussed above may result in improved return loss, when compared with conventional output driver circuits. For example, FIG. 4 is a chart illustrating differential return loss versus frequency for a conventional on-chip differential output driver circuit (trace 402), and an on-chip differential output driver circuit with a T-coil implementation (trace 404), according to an embodiment. As can be seen in the chart, the differential output driver circuit with the T-coil implementation places an imaginary zero in the response, which provides a return loss matching notch 406 at the desired operational frequency (e.g., 14 GHz in the illustrated example for a 28 Gbps application). More specifically, the matching notch 406 is approximately 22 decibels (dB) down at a frequency of about 14 GHz. Further, the notch 406 is fairly broadband, in that the return loss is significantly depressed over a fairly wide range of frequencies surrounding the desired operational frequency.

In addition, embodiments of the on-chip differential output driver circuits discussed above may produce an inductive peaking effect that extends the bandwidth. For example, FIG. 5 is a chart illustrating normalized gain versus frequency for a conventional on-chip differential output driver circuit (trace 502), and an on-chip differential output driver circuit with a T-coil implementation (trace 504), according to an embodiment. As shown in the chart, with a conventional output driver circuit, a smooth rolloff begins to occur at about 2 GHz, and the gain is about 3 dB down at about 16.7 GHz. Conversely, the T-coil implementation in an embodiment of the output driver circuit produces an inductive peaking effect that extends the bandwidth. In the illustrated example, the 3 dB rolloff point occurs at about 33.7 GHz. Thus, implementation of the T-coil in the output driver circuit resulted in extension of the bandwidth by about two times.

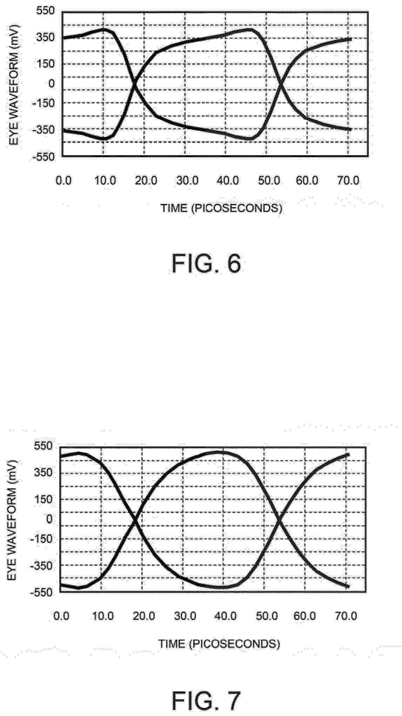

In addition, embodiments of the on-chip differential output driver circuits discussed above may result in reduced signal distortion, when compared with a conventional output driver circuit. This is indicated, for example, by comparing the transient eye diagrams in FIGs 6 and 7. More specifically, FIG. 6 illustrates a transient eye diagram for a conventional output driver circuit, and FIG. 7 illustrates a transient eye diagram for an embodiment of an output driver circuit with a T-coil implementation. The peak-to-peak amplitude at the center of the eye in FIG. 6 is approximately 0.7 volts, while the peak-to-peak amplitude at the center of the eye in FIG. 7 is nearly 1 volt. Further, relatively significant closure may be observed in the eye diagram of FIG. 6, when compared with the eye diagram of FIG. 7. Essentially, the transient eye diagram may be improved dramatically with the T-coil implementation due to its potential improvements in return loss and bandwidth.

An embodiment of an output driver circuit includes an output terminal configured to produce an output signal, a complementary data switch pair, and a T-coil. The complementary data switch pair is coupled between a voltage source and a ground reference node. The complementary data switch pair includes a first transistor and a second transistor, each with a control terminal, a first current conducting terminal, and a second current conducting terminal. The first current conducting terminals of the first and second transistors are coupled together at an output node, and the control terminals of the first and second transistors are configured to receive an input signal. The T-coil is coupled to the output node. The T-coil includes a first coil coupled between the output node and the output terminal, and a second coil coupled between the output node and a termination. A mutual inductance (e.g., a positive mutual inductance) is present between the first coil and the second coil during operation of the output driver circuit.

An embodiment of a differential output driver circuit includes a first output terminal configured to produce a first output signal, a second output terminal configured to produce a second output signal, first and second complementary data switch pairs, and first and second T-coils.

The first and second output signals are complementary signals of a differential output signal. The first complementary data switch pair is coupled between a voltage source and a ground reference node. The first complementary data switch pair includes a pair of first complementary transistors, where each of the first complementary transistors includes a control terminal, a first current conducting terminal, and a second current conducting terminal. The first current conducting terminals of the first complementary transistors are coupled together at a first output node, and the control terminals of the first complementary transistors are configured to receive a first input signal. The second complementary data switch pair is coupled in parallel with the first complementary data switch pair between the voltage source and the ground reference node. The second complementary data switch pair includes a pair of second complementary transistors, where each of the second complementary transistors includes a control terminal, a first current conducting terminal, and a second current conducting terminal. The first current conducting terminals of the second complementary transistors are coupled together at a second output node, and the control terminals of the second complementary transistors are configured to receive a second input signal that is complementary to the first input signal. The first T-coil is coupled to the first output node, and the first T-coil includes a first coil coupled between the first output node and the first output terminal, and a second coil coupled between the first output node and a first termination. A mutual inductance (e.g., a positive mutual inductance) is present between the first coil and the second coil during operation of the output driver circuit. The second T-coil coupled to the second output node, and the second T-coil includes a third coil coupled between the second output node and the second output terminal, and a fourth coil coupled between the second output node and a second termination. A mutual inductance (e.g., a positive mutual inductance) is present between the third coil and the fourth coil during operation of the output driver circuit.

An embodiment of a transmitter IC includes a serializer and an output driver circuit. The serializer is configured to convert a parallel transmit signal into a serialized bit stream. The output driver circuit is coupled to the serializer, and is configured to receive the serialized bit stream, to modify the serialized bit stream, and to drive the modified serialized bit stream onto a channel. The output driver circuit includes an output terminal configured to produce an output signal, a complementary data switch pair, and a T-coil. The complementary data switch pair is coupled between a voltage source and a ground reference node. The complementary data switch pair includes first and second transistors, each with a control terminal, a first current conducting terminal, and a second current conducting terminal. The first current conducting terminals of the first and second transistors are coupled together at an output node, and the control terminals of the first and second transistors are configured to receive the serialized bit stream. The T-coil is coupled to the output node. The T-coil includes a first coil coupled between the output node and the output terminal, and a second coil coupled between the output node and a termination. A mutual inductance (e.g., a positive mutual inductance) is present between the first coil and the second coil during operation of the output driver circuit.

An embodiment of a method of operating an output driver circuit includes modifying a first data signal using a first complementary data switch pair coupled between a voltage source and a ground reference node. The first complementary data switch pair includes a pair of first complementary transistors, where each of the first complementary transistors includes a control terminal, a first current conducting terminal, and a second current conducting terminal. The first current conducting terminals of the first complementary transistors are coupled together at a first output node, and the control terminals of the first complementary transistors are configured to receive a first input signal. The method further includes compensating for output capacitance of the first complementary data switch pair using an inductive filter comprised of a first T-coil coupled to the first output node. The first T-coil includes a first coil coupled between the first output node and a first output terminal, and a second coil coupled between the first output node and a first termination. A mutual inductance is present between the first coil and the second coil during operation of the output driver circuit.

In a further embodiment the output driver circuit is a differential output driver circuit, and the method further includes modifying a second data signal using a second complementary data switch pair coupled in parallel with the first complementary data switch pair between the voltage source and the ground reference node. The second complementary data switch pair includes a pair of second complementary transistors, where each of the second complementary transistors includes a control terminal, a first current conducting terminal, and a second current conducting terminal. The first current conducting terminals of the second complementary transistors are coupled together at a second output node, and the control terminals of the second complementary transistors are configured to receive a second input signal that is complementary to the first input terminal. The further embodiment also includes compensating for output capacitance of the second complementary data switch pair using an inductive filter comprised of a second T-coil coupled to the second output node. The second T-coil includes a third coil coupled between the second output node and a second output terminal, and a fourth coil coupled between the second output node and a second termination. A mutual inductance is present between the third coil and the fourth coil during operation of the output driver circuit.

The foregoing detailed description is merely illustrative in nature and is not intended to limit the embodiments of the subject matter or the application and uses of such embodiments. As used herein, the words "exemplary" and "example" mean "serving as an example, instance, or illustration." Any implementation described herein as exemplary or an example is not necessarily to be construed as preferred or advantageous over other implementations. Furthermore, there is no intention to be bound by any expressed or implied theory presented in the foregoing technical field, background, or detailed description.

For the sake of brevity, conventional semiconductor fabrication techniques may not be described in detail herein. In addition, certain terminology may also be used herein for the purpose of reference only, and thus are not intended to be limiting, and the terms "first", "second" and other such numerical terms referring to structures do not imply a sequence or order unless clearly indicated by the context.

The foregoing description refers to elements or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. An output driver circuit, comprising:
a first output terminal (250) configured to produce a first output signal;
a first complementary data switch pair coupled between a voltage source and a ground reference node, wherein the first complementary data switch pair includes
a first transistor (220) with a control terminal (221), a first current conducting terminal, and a second current conducting terminal, and
a second transistor (222) with a control terminal (223), a first current conducting terminal, and a second current conducting terminal,
wherein the first current conducting terminals of the first and second transistors are coupled together at a first output node (224), and wherein the control terminals of the first and second transistors are configured to receive a first input signal; and
a first T-coil with a centre tap between a first coil and a second coil, wherein the centre tap is directly coupled to the first output node between the first current conducting terminals of the first and second transistors, wherein the first coil (233) of the first T-coil is coupled between the first output node and the first output terminal, and the second coil (232) is coupled between the first output node and a first termination, wherein a mutual inductance is present between the first coil and the second coil during operation of the output driver circuit.

2. The output driver circuit of claim 1, wherein inductances of the first and second coils are configured so that the mutual inductance between the first coil and the second coil during operation of the output driver circuit substantially filters out an output capacitance of the first complementary data switch pair.

3. The output driver circuit of claim 1, further comprising:
a second output terminal (252) configured to produce a second output signal, wherein the first and second output signals are complementary signals of a differential output signal;
a second complementary data switch pair coupled in parallel with the first complementary data switch pair between the voltage source and the ground reference node, wherein the second complementary data switch pair includes
a third transistor (225) with a control terminal (226), a first current conducting terminal, and a second current conducting terminal, and
a fourth transistor (227) with a control terminal (228), a first current conducting terminal, and a second current conducting terminal,
wherein the first current conducting terminals of the third and fourth transistors are coupled together at a second output node (229), and wherein the control terminals of the third and fourth transistors are configured to receive a second input signal that is complementary to the first input signal; and
a second T-coil coupled to the second output node, wherein the second T-coil includes a third coil (237) coupled between the second output node and the second output terminal, and a fourth coil (236) coupled between the second output node and a second termination, wherein a mutual inductance is present between the third coil and the fourth coil during operation of the output driver circuit.

4. The output driver circuit of claim 3, wherein:
the first termination includes a first resistor (234) coupled between the second coil and a common mode node (230);
the second termination includes a second resistor (238) coupled between the fourth coil and the common mode node, and
the common mode node is coupled to the ground voltage reference.

5. The output driver circuit of claim 4, wherein the common mode node is coupled to the ground voltage reference through a common mode capacitor (240) that has a low impedance to AC signals.

6. The output driver circuit of claim 3, wherein the first output terminal, the second output terminal, the first complementary data switch pair, the second complementary data switch pair, the first T-coil, and the second T-coil all are integrated into a single integrated circuit (200).

7. The output driver circuit of any one of the claims 3 to 6, wherein:
the output driver circuit is a differential output driver circuit,
the first transistor and the second transistor form a pair of first complementary transistors,
the third transistor and the fourth transistor form a pair of second complementary transistors.

8. The output driver circuit of any one of the claims 3 to 7, wherein:
inductances of the first and second coils are configured so that the mutual inductance between the first coil and the second coil during operation of the differential output driver circuit substantially filters out an output capacitance of the first complementary data switch pair; and
inductances of the third and fourth coils are configured so that the mutual inductance between the third coil and the fourth coil during operation of the differential output driver circuit substantially filters out an output capacitance of the second complementary data switch pair.

9. A transmitter integrated circuit comprising:
a serializer (132) configured to convert a parallel transmit signal (110) into a first serialized bit stream (112); and
an output driver circuit (134) coupled to the serializer, and configured to receive the first serialized bit stream, to modify the first serialized bit stream, and to drive the first modified serialized bit stream onto a channel (150), wherein the output driver circuit is an output driver circuit according to any one of the claims 1 to 8.

10. A method of operating an output driver circuit, the method comprising the steps of:
modifying (308) a first data signal using a first complementary data switch pair coupled between a voltage source and a ground reference node, wherein the first complementary data switch pair includes a pair of first complementary transistors (220, 222), wherein each of the first complementary transistors includes a control terminal (221, 223), a first current conducting terminal, and a second current conducting terminal, wherein the first current conducting terminals of the first complementary transistors are coupled together at a first output node (224), and wherein the control terminals of the first complementary transistors are configured to receive a first input signal; and
compensating (310) for output capacitance of the first complementary data switch pair using an inductive filter comprised of a first T-coil with a centre tap between a first coil and a second coil, wherein the centre tap is directly coupled to the first output node between the first conducting terminals of the first and second transistors, wherein the first coil (233) of the first T-coil is coupled between the first output node (250) and a first output terminal, and the second coil (232) of the first T coil is coupled between the first output node and a first termination, wherein a mutual inductance is present between the first coil and the second coil during operation of the output driver circuit.

11. The method of claim 10, wherein the output driver circuit is a differential output driver circuit, and the method further comprises:
modifying (308) a second data signal using a second complementary data switch pair coupled in parallel with the first complementary data switch pair between the voltage source and the ground reference node, wherein the second complementary data switch pair includes a pair of second complementary transistors (225, 227), wherein each of the second complementary transistors includes a control terminal (226, 228), a first current conducting terminal, and a second current conducting terminal, wherein the first current conducting terminals of the second complementary transistors are coupled together at a second output node, and wherein the control terminals of the second complementary transistors are configured to receive a second input signal that is complementary to the first input terminal; and
compensating (310) for output capacitance of the second complementary data switch pair using an inductive filter comprised of a second T-coil coupled to the second output node, wherein the second T-coil includes a third coil (237) coupled between the second output node and a second output terminal (252), and a fourth coil (236) coupled between the second output node and a second termination, wherein a mutual inductance is present between the third coil and the fourth coil during operation of the output driver circuit.

12. The method of claim 11, further comprising:
driving (312) a differential output signal that includes the modified first data signal and the modified second data signal onto a differential channel (150).

13. The method of claim 11 or claim 12, further comprising:
before modifying the first data signal and modifying the second data signal, receiving a parallel transmit signal (110);
converting the parallel transmit signal into serialized complementary bit streams (114) that include the first signal and the second signal; and
providing the first and second signals to the first and second complementary data switch pairs.

## Patentansprüche

1. Ausgangstreiberschaltung mit:
einem ersten Ausgangsanschluss (250), der dazu konfiguriert ist, ein erstes Ausgangssignal zu erzeugen;
einem ersten komplementären Datenschalterpaar, das zwischen einer Spannungsquelle und einem Massereferenzknoten gekoppelt ist, wobei das erste komplementäre Datenschalterpaar Folgendes aufweist:
einen ersten Transistor (220) mit einem Steueranschluss (221), einem ersten Stromleitungsanschluss und einem zweiten Stromleitungsanschluss, und
einen zweiten Transistor (222) mit einem Steueranschluss (223), einem ersten Stromleitungsanschluss und einem zweiten Stromleitungsanschluss,
wobei die ersten Stromleitungsanschlüsse des ersten und des zweiten Transistors zusammen an einem ersten Ausgangsknoten (224) gekoppelt sind, und wobei die Steueranschlüsse des ersten und des zweiten Transistors dazu konfiguriert sind, ein erstes Eingangssignal aufzunehmen; und
einer ersten T-Spule mit einem Mittelabgriff zwischen einer ersten Spule und einer zweiten Spule, wobei der Mittelabgriff direkt mit dem ersten Ausgangsknoten zwischen den ersten Stromleitungsanschlüssen des ersten und des zweiten Transistors gekoppelt ist, wobei die erste Spule (233) der ersten T-Spule zwischen dem ersten Ausgangsknoten und dem ersten Ausgangsanschluss gekoppelt ist und die zweite Spule (232) zwischen dem ersten Ausgangsknoten und einem ersten Endanschluss gekoppelt ist, wobei eine gegenseitige Induktivität zwischen der ersten Spule und der zweiten Spule während eines Betriebs der Ausgangstreiberschaltung vorhanden ist.

2. Ausgangstreiberschaltung gemäß Anspruch 1, wobei Induktivitäten der ersten und der zweiten Spule so konfiguriert sind, dass die gegenseitige Induktivität zwischen der ersten Spule und der zweiten Spule während eines Betriebs der Ausgangstreiberschaltung eine Ausgangskapazität des ersten komplementären Datenschalterpaars im Wesentlichen herausfiltert.

3. Ausgangstreiberschaltung gemäß Anspruch 1, des Weiteren mit:
einem zweiten Ausgangsanschluss (252), der dazu konfiguriert ist, ein zweites Ausgangssignal zu erzeugen, wobei das erste und das zweite Ausgangssignal komplementäre Signale eines Differentialausgangssignals sind;
einem zweiten komplementären Datenschalterpaar, das parallel mit dem ersten komplementären Datenschalterpaar zwischen der Spannungsquelle und dem Massereferenzknoten gekoppelt ist, wobei das zweite komplementäre Datenschalterpaar Folgendes aufweist:
einen dritten Transistor (225) mit einem Steueranschluss (226), einem ersten Stromleitungsanschluss und einem zweiten Stromleitungsanschluss, und
einen vierten Transistor (227) mit einem Steueranschluss (228), einem ersten Stromleitungsanschluss und einem zweiten Stromleitungsanschluss,
wobei die ersten Stromleitungsanschlüsse des dritten und des vierten Transistors zusammen an einem zweiten Ausgangsknoten (229) gekoppelt sind, und wobei die Steueranschlüsse des dritten und des vierten Transistors dazu konfiguriert sind, ein zweites Eingangssignal aufzunehmen, das komplementär zu dem ersten Eingangssignal ist; und
einer zweiten T-Spule, die mit dem zweiten Ausgangsknoten gekoppelt ist, wobei die zweite T-Spule eine dritte Spule (237), die zwischen dem zweiten Ausgangsknoten und dem zweiten Ausgangsanschluss gekoppelt ist, und eine vierte Spule (236) aufweist, die zwischen dem zweiten Ausgangsknoten und einem zweiten Endanschluss gekoppelt ist, wobei eine gegenseitige Induktivität zwischen der dritten Spule und der vierten Spule während eines Betriebs der Ausgangstreiberschaltung vorhanden ist.

4. Ausgangstreiberschaltung gemäß Anspruch 3, wobei:
der erste Endanschluss einen ersten Widerstand (234) aufweist, der zwischen der zweiten Spule und einem Gleichtaktknoten (230) gekoppelt ist;
wobei der zweite Endanschluss einen zweiten Widerstand (238) aufweist, der zwischen der vierten Spule und dem Gleichtaktknoten gekoppelt ist, und
der Gleichtaktknoten mit der Massespannungsreferenz gekoppelt ist.

5. Ausgangstreiberschaltung gemäß Anspruch 4, wobei der Gleichtaktknoten mit der Massespannungsreferenz durch einen Gleichtaktkondensator (240) gekoppelt ist, der eine niedrige Impedanz für AC-Signale hat.

6. Ausgangstreiberschaltung gemäß Anspruch 3, wobei der erste Ausgangsanschluss, der zweite Ausgangsanschluss, das erste komplementäre Datenschalterpaar, das zweite komplementäre Datenschalterpaar, die erste T-Spule und die zweite T-Spule allesamt in einer einzigen integrierten Schaltung (200) integriert sind.

7. Ausgangstreiberschaltung gemäß einem der Ansprüche 3 bis 6, wobei:
die Ausgangstreiberschaltung eine Differentialausgangstreiberschaltung ist,
der erste Transistor und der zweite Transistor ein Paar von ersten komplementären Transistoren bilden,
der dritte Transistor und der vierte Transistor ein Paar von zweiten komplementären Transistoren bilden.

8. Ausgangstreiberschaltung gemäß einem der Ansprüche 3 bis 7, wobei:
Induktivitäten der ersten und der zweiten Spule so konfiguriert sind, dass die gegenseitige Induktivität zwischen der ersten Spule und der zweiten Spule während eines Betriebs der Differentialausgangstreiberschaltung eine Ausgangskapazität des ersten komplementären Datenschalterpaares im Wesentlichen herausfiltert; und
Induktivitäten der dritten und der vierten Spule so konfiguriert sind, dass die gegenseitige Induktivität zwischen der dritten Spule und der vierten Spule während eines Betriebs der Differentialausgangstreiberschaltung eine Ausgangskapazität des zweiten komplementären Datenschalterpaares im Wesentlichen herausfiltert.

9. Integrierte Sendeschaltung mit:
einem Seriellumsetzer (132), der dazu konfiguriert ist, ein paralleles Sendesignal (110) zu einem ersten serialisierten Bitstream (112) zu wandeln; und
einer Ausgangstreiberschaltung (134), die mit dem Seriellumsetzer gekoppelt und dazu konfiguriert ist, den ersten serialisierten Bitstream aufzunehmen, den ersten serialisierten Bitstream abzuwandeln und den ersten abgewandelten serialisierten Bitstream auf einem Kanal (150) zu treiben, wobei die Ausgangstreiberschaltung eine Ausgangstreiberschaltung gemäß einem der Ansprüche 1 bis 8 ist.

10. Verfahren zum Betreiben einer Ausgangstreiberschaltung, wobei das Verfahren die folgenden Schritte aufweist:
Abwandeln (308) eines ersten Datensignals unter Verwendung eines ersten komplementären Datenschalterpaares, das zwischen einer Spannungsquelle und einem Massereferenzknoten gekoppelt ist, wobei das erste komplementäre Datenschalterpaar ein Paar von ersten komplementären Transistoren (220, 222) aufweist, wobei die ersten komplementären Transistoren jeweils einen Steueranschluss (221, 223), einen ersten Stromleitungsanschluss und einen zweiten Stromleitungsanschluss aufweisen, wobei die ersten Stromleitungsanschlüsse der ersten komplementären Transistoren zusammen an einem ersten Ausgangsknoten (224) gekoppelt sind, und wobei die Steueranschlüsse der ersten komplementären Transistoren dazu konfiguriert sind, ein erstes Eingangssignal aufzunehmen; und
Ausgleichen (310) einer Ausgangskapazität des ersten komplementären Datenschalterpaares unter Verwendung eines induktiven Filters, der eine erste T-Spule mit einem Mittelabgriff zwischen einer ersten Spule und einer zweiten Spule aufweist, wobei der Mittelabgriff mit dem ersten Ausgangsknoten zwischen den ersten Leitungsanschlüssen des ersten und des zweiten Transistors direkt gekoppelt ist, wobei die erste Spule (233) der ersten T-Spule zwischen dem ersten Ausgangsknoten (250) und einem ersten Ausganganschluss gekoppelt ist und die zweite Spule (232) der ersten T-Spule zwischen dem ersten Ausgangsknoten und einem ersten Endanschluss gekoppelt ist, wobei eine gegenseitige Induktivität zwischen der ersten Spule und der zweiten Spule während eines Betriebs der Ausgangstreiberschaltung vorhanden ist.

11. Verfahren gemäß Anspruch 10, wobei die Ausgangstreiberschaltung eine Differentialausgangstreiberschaltung ist und das Verfahren des Weiteren Folgendes aufweist:
Abwandeln (308) eines zweiten Datensignals unter Verwendung eines zweiten komplementären Datenschalterpaares, das parallel mit dem ersten komplementären Datenschalterpaar zwischen der Spannungsquelle und dem Massereferenzknoten gekoppelt ist, wobei das zweite komplementäre Datenschalterpaar ein Paar von zweiten komplementären Transistoren (225, 227) aufweist, wobei die zweiten komplementären Transistoren jeweils einen Steueranschluss (226, 228), einen ersten Stromleitungsanschluss und einen zweiten Stromleitungsanschluss aufweisen, wobei die ersten Stromleitungsanschlüsse der zweiten komplementären Transistoren zusammen an einem zweiten Ausgangsknoten gekoppelt sind, und wobei die Steueranschlüsse der zweiten komplementären Transistoren dazu konfiguriert sind, ein zweites Eingangssignal aufzunehmen, das komplementär zu dem ersten Eingangsanschluss ist; und
Ausgleichen (310) einer Ausgangskapazität des zweiten komplementären Datenschalterpaares unter Verwendung eines induktiven Filters, der eine zweite T-Spule aufweist, die mit dem zweiten Ausgangsknoten gekoppelt ist, wobei die zweite T-Spule eine dritte Spule (237), die zwischen dem zweiten Ausgangsknoten und einem zweiten Ausgangsanschluss (252) gekoppelt ist, und eine vierte Spule (236) aufweist, die zwischen dem zweiten Ausgangsknoten und einem zweiten Endanschluss gekoppelt ist, wobei eine gegenseitige Induktivität zwischen der dritten Spule und der vierten Spule während eines Betriebs der Ausgangstreiberschaltung vorhanden ist.

12. Verfahren gemäß Anspruch 11, des Weiteren mit:
Treiben (312) eines Differentialausgangssignals, das das abgewandelte erste Datensignal und das abgewandelte zweite Datensignal enthält, auf einen Differentialkanal (150).

13. Verfahren gemäß Anspruch 11 oder Anspruch 12, des Weiteren mit:
Aufnehmen eines parallelen Sendesignals (110) vor einem Abwandeln des ersten Datensignals und einem Abwandeln des zweiten Datensignals;
Wandeln des parallelen Sendesignals zu serialisierten komplementären Bitstreams (114), die das erste Signal und das zweite Signal enthalten; und
Bereitstellen des ersten und des zweiten Signals für das erste und das zweite komplementäre Datenschalterpaar.

## Revendications

1. Circuit d'attaque de sortie, comprenant
une première borne de sortie (250) configurée pour produire un premier signal de sortie;
une première paire de commutateurs de données complémentaires couplée entre une source de tension et un noeud de référence de mise à la terre, dans lequel la première paire de commutateurs de données complémentaires comporte
un premier transistor (220) comportant une borne de commande (221), une première borne de conduction de courant, et une seconde borne de conduction de courant, et
un deuxième transistor (222) comportant une borne de commande (223), une première borne de conduction de courant, et une seconde borne de conduction de courant,
dans lequel les premières bornes de conduction de courant des premier et deuxième transistors sont couplées ensemble au niveau d'un premier noeud de sortie (224), et dans lequel les bornes de commande des premier et deuxième transistors sont configurées pour recevoir un premier signal d'entrée ; et
une première bobine en T présentant une prise centrale entre une première bobine et une deuxième bobine, dans lequel la prise centrale est couplée directement au premier noeud de sortie entre les premières bornes de conduction de courant des premier et deuxième transistors, dans lequel la première bobine (233) de la première bobine en T est couplée entre le premier noeud de sortie et la première borne de sortie, et la deuxième bobine (232) est couplée entre le premier noeud de sortie et une première terminaison, dans lequel une inductance mutuelle est présente entre la première bobine et la deuxième bobine durant le fonctionnement du circuit d'attaque de sortie.

2. Circuit d'attaque de sortie selon la revendication 1, dans lequel des inductances des première et deuxième bobines sont configurées de telle sorte que l'inductance mutuelle entre la première bobine et la deuxième bobine durant le fonctionnement du circuit d'attaque de sortie élimine sensiblement par filtrage une capacité de sortie de la première paire de commutateurs de données complémentaires.

3. Circuit d'attaque de sortie selon la revendication 1, comprenant en outre :
une seconde borne de sortie (252) configurée pour produire un second signal de sortie, dans lequel les premier et second signaux de sortie sont des signaux complémentaires d'un signal de sortie différentiel ; une seconde paire de commutateurs de données complémentaires couplée en parallèle à la première paire de commutateurs de données complémentaires entre la source de tension et le noeud de référence de terre, dans lequel la seconde paire de commutateurs de données complémentaires comporte
un troisième transistor (225) présentant une borne de commande (226), une première borne de conduction de courant, et une seconde borne de conduction de courant, et
un quatrième transistor (227) présentant une borne de commande (228), une première borne de conduction de courant, et une seconde borne de conduction de courant,
dans lequel les premières bornes de conduction de courant des troisième et quatrième transistors sont couplées ensemble au niveau d'un second noeud de sortie (229), et dans lequel les bornes de commande des troisième et quatrième transistors sont configurées pour recevoir un second signal d'entrée qui est complémentaire du premier signal d'entrée ; et une seconde bobine en T couplée au second noeud de sortie, dans lequel la seconde bobine en T comporte une troisième bobine (237) couplée entre le second noeud de sortie et la borne de sortie, et une quatrième bobine (236) couplée entre le second noeud de sortie et une seconde terminaison, dans lequel une inductance mutuelle est présente entre la troisième bobine et la quatrième bobine durant le fonctionnement du circuit d'attaque de sortie.

4. Circuit d'attaque de sortie selon la revendication 3, dans lequel :
la première terminaison comporte une première résistance (234) couplée entre la deuxième bobine et un noeud de mode commun (230) ;
la seconde terminaison comporte une seconde résistance (238) couplée entre la quatrième bobine et le noeud de mode commun, et
le noeud de mode commun est couplé à la référence de tension de mise à la terre.

5. Circuit d'attaque de sortie selon la revendication 4, dans lequel le noeud de mode commun est couplé à la référence de tension de mise à la terre par le biais d'un condensateur de mode commun (240) qui présente une faible impédance vis-à-vis des signaux C.A.

6. Circuit d'attaque de sortie selon la revendication 3, dans lequel la première borne de sortie, la seconde borne de sortie, la première paire de commutateurs de données complémentaires, la seconde paire de commutateurs de données complémentaires, la première bobine en T, et la seconde bobine en T sont toutes intégrées dans un même circuit intégré (200).

7. Circuit d'attaque de sortie selon l'une quelconque des revendications 3 à 6, dans lequel :
le circuit d'attaque de sortie est un circuit d'attaque de sortie différentiel,
le premier transistor et le deuxième transistor forment une paire de premiers transistors complémentaires,
le troisième transistor et le quatrième transistor forment une paire de seconds transistors complémentaires.

8. Circuit d'attaque de sortie différentiel selon l'une quelconque des revendications 3 à 7, dans lequel :
des inductances des première et deuxième bobines sont configurées de telle sorte que l'inductance mutuelle entre la première bobine et la deuxième bobine durant le fonctionnement du circuit d'attaque de sortie différentiel élimine sensiblement par filtrage une capacité de sortie de la première paire de commutateurs de données complémentaires ; et
des inductances des troisième et quatrième bobines sont configurées de telle sorte que l'inductance mutuelle entre la troisième bobine et la quatrième bobine durant le fonctionnement du circuit d'attaque de sortie différentiel élimine sensiblement par filtrage une capacité de sortie de la seconde paire de commutateurs de données complémentaires.

9. Circuit intégré émetteur comprenant :
un sérialiseur (132) configuré pour convertir un signal d'émission parallèle (110) en un premier train binaire sérialisé (112) ; et
un circuit d'attaque de sortie (134) couplé au sérialiseur, et configuré pour recevoir le premier train binaire sérialisé, afin de modifier le premier train binaire sérialisé, et acheminer le premier train binaire sérialisé modifié sur un canal (150), dans lequel le circuit d'attaque de sortie est un circuit d'attaque de sortie selon l'une quelconque des revendications 1 à 8.

10. Procédé de fonctionnement d'un circuit d'attaque de sortie, le procédé comprenant les étapes suivantes :
modification (308) d'un premier signal de données en utilisant une première paire de commutateurs de données complémentaires couplée entre une source de tension et un noeud de référence de mise à la terre, dans lequel la première paire de commutateurs de données complémentaires comporte une paire de premiers transistors complémentaires (220, 222), dans lequel chacun des premiers transistors complémentaires comporte une borne de commande (221, 223), une première borne de conduction de courant, et une seconde borne de conduction de courant, dans lequel les premières bornes de conduction de courant des premiers transistors complémentaires sont couplées ensemble au niveau d'un premier noeud de sortie (224), et dans lequel les bornes de commande des premiers transistors complémentaires sont configurées pour recevoir un premier signal d'entrée ; et
la compensation (310) de la capacité de sortie de la première paire de commutateurs de données complémentaires en utilisant un filtre inductif composé d'une première bobine en T présentant une prise centrale entre une première bobine et une deuxième bobine, dans lequel la prise centrale est couplée directement au premier noeud de sortie entre les premières bornes de conduction des premier et deuxième transistors, dans lequel la première bobine (233) de la première bobine en T est couplée entre le premier noeud de sortie (250) et une première borne de sortie, et la deuxième bobine (232) de la première bobine en T est couplée entre le premier noeud de sortie et une première terminaison, dans lequel une inductance mutuelle est présente entre la première bobine et la deuxième bobine durant le fonctionnement du circuit d'attaque de sortie.

11. Procédé selon la revendication 10, dans lequel le circuit d'attaque de sortie est un circuit d'attaque de sortie différentiel, et le procédé comprend en outre :
la modification (308) d'un second signal de données en utilisant une seconde paire de commutateurs de données complémentaires couplée en parallèle avec la première paire de commutateurs de données complémentaires entre la source de tension et le noeud de référence de terre, dans lequel la seconde paire de commutateurs de données complémentaires comporte une paire de seconds transistors complémentaires (225, 227), dans lequel chacun des seconds transistors complémentaires comporte une borne de commande (226, 228), une première borne de conduction de courant, et une seconde borne de conduction de courant, dans lequel les premières bornes de conduction de courant des seconds transistors complémentaires sont couplées ensemble au niveau d'un second noeud de sortie, et dans lequel les bornes de commande des seconds transistors complémentaires sont configurées pour recevoir un second signal d'entrée qui est complémentaire de la première borne d'entrée ; et
la compensation (310) de la capacité de sortie de la seconde paire de commutateurs de données complémentaires en utilisant un filtre inductif composé d'une seconde bobine en T couplée au second noeud de sortie, dans lequel la seconde bobine en T comporte une troisième bobine (237) couplée entre le second noeud de sortie et une seconde borne de sortie (252), et une quatrième bobine (236) couplée entre le second noeud de sortie et une seconde terminaison, dans lequel une inductance mutuelle est présente entre la troisième bobine et la quatrième bobine durant le fonctionnement du circuit d'attaque de sortie.

12. Procédé selon la revendication 11, comprenant en outre :
l'acheminement (312) d'un signal de sortie différentiel qui comporte le premier signal de données modifié et le second signal de données modifié sur un canal différentiel (150).

13. Procédé selon la revendication 11 ou la revendication 12, comprenant en outre :
avant la modification du premier signal de données et la modification du second signal de données, la réception d'un signal d'émission parallèle (110);
la conversion du signal d'émission parallèle en trains binaires complémentaires sérialisés (114) qui comportent le premier signal et le second signal ; et
la fourniture des premier et second signaux aux première et seconde paires de commutateurs de données complémentaires.
